(19) Europäisches Patentamt
European Patent Office
Office européen des brevets

(11) Publication number: 0 032 042 B1

(12) EUROPEAN PATENT SPECIFICATION

(45) Date of publication of patent specification: 28.08.85

(51) Int. Cl.$^4$: H 01 L 29/04, H 01 L 29/78

(21) Application number: 80304668.9

(22) Date of filing: 22.12.80

(54) An insulated gate field effect transistor.

(30) Priority: 28.12.79 JP 170983/79

(43) Date of publication of application:
15.07.81 Bulletin 81/28

(45) Publication of the grant of the patent:
28.08.85 Bulletin 85/35

(84) Designated Contracting States:
DE FR GB NL

(56) References cited:
DE-A-1 817 354
FR-A-2 148 166
GB-A-2 007 430
US-A-3 920 492
US-A-4 179 311

JOURNAL OF PHYSICAL CHEMISTRY, vol. 65, no. 11, November 1961, Easton, pa, (US) J.R. LIGENZA: "Effect of Crystal Orientation on Oxidation Rates of Silicon in High Pressure Steam", pages 2011-2014
JAPANESE JOURNAL OF APPLIED PHYSICS, vol. 7, no. 6, 1968, Tokyo (JP) Y. TAKEISHI et al.: "Characteristic Properties of Si(311) Surfaces" page 679

(73) Proprietor: FUJITSU LIMITED
1015, Kamikodanaka Nakahara-ku
Kawasaki-shi Kanagawa 211 (JP)

(72) Inventor: Wada, Kunihiko
7-1-1234, Sugita
Isogo-ku, Yokohama-shi Kanagawa 235 (JP)
Inventor: Nakano, Motoo
312-3-9-913, Imai-cho
Hodogaya-ku, Yokohama-shi Kanagawa 240 (JP)

(74) Representative: Sunderland, James Harry et al
HASELTINE LAKE & CO Hazlitt House 28
Southampton Buildings Chancery Lane
London WC2A 1AT (GB)

(56) References cited:
JOURNAL OF THE ELECTROCHEMICAL SOCIETY, vol. 123, no. 1, January 1976, Princeton (US) A.P. TURLEY et al.: "Fabrication of P-channel Silicon Gate LSI Devices with Si3N4/SiO2 Gate Dielectric", pages 117-120
JAPANESE JOURNAL OF APPLIED PHYSICS, vol. 17, no. 4, 1978 Tokyo (JP) K. OHWADA et al.: "Gate Oxide Defects near the Selectively Oxidized Silicon", pages 737-738

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 032 042 B1

**Description**

The present invention relates to an insulated gate field effect transistor (IGFET).

In an IGFET which has been subjected to a selective oxidation process using an $Si_3N_4$ film as a mask a parastic channel effect is less marked since a silicon dioxide film ($SiO_2$ film) on areas other than the gate of the transistor is sufficiently thick to suppress this effect. On the other hand, when adopted more especially in integrated circuits (IC's), such as IGFET can provide excellent effects such as improved integration density and reduction in the frequency of occurrence of disconnections in wiring. However, the use of such a selective oxidation process brings about the possibility of dielectric breakdown of a gate insulating film at a low voltage when an electric field is applied to a substrate from a gate electrode via the gate insulating film. Namely, such an IGFET suffers a problem in that the breakdown voltage of the gate insulating film is reduced as a consequence of the employment of the abovementioned selective oxidation process.

Figures 1 to 3 of the accompanying drawings illustrate the formation of a field oxide film by selective oxidation in an ordinary IGFET, and the causes of reduced breakdown voltage for a gate insulating film will be considered with reference to these Figures.

Firstly, as indicated in Figure 1, which is a schematic cross-sectional view, a silicon dioxide film 2 ($SiO_2$ film) is formed to a thickness of about 500 Å over the entire surface of a single crystal silicon substrate 1, and then a silicon nitride film ($Si_3N_4$ film) 3 is selectively formed to a similar thickness on the $SiO_2$ film 2. Next, as indicated in Figure 2a, a field oxide film 22 is caused to grow to a thickness of about 800 nm (8000 Å) on the single crystal silicon substrate 1, except on a region (under the film 3) which will provide a gate, in a high temperature oxidising atmosphere containing water vapour. However, in this selective oxidation process, $H_2O$ in the water vapour and the $Si_3N_4$ film 3 react chemically as expressed by the reaction (1) below, producing $NH_3$.

$$Si_3N_4+6H_2O=4NH_3+3SiO_2 \qquad (1)$$

The ammonia ($NH_3$) can easily pass through the $SiO_2$ film and therefore the $NH_3$ generated by reaction (1) can reach the area under the $SiO_2$ film 2 which is for providing a gate region and can then react with the single crystal silicon substrate 1 in accordance with reaction (2) below, producing $Si_3N_4$ regions 21 and 23 as shown.

$$3Si+4NH_3=Si_3N_4+6H_2 \qquad (2)$$

Among the $Si_3N_4$ regions 21 and 23 produced by the reaction (2), $Si_3N_4$ regions 21 at the boundary of the single crystal silicon substrate 1 under the end or edge of the oxidation resistant mask 3 of $Si_3N_4$ are called the "White Ribbon". As indicated in Figure 2b, which is an enlarged view of a part of Figure 2a, these $Si_3N_4$ regions 21 are generated by seepage of $H_2O$ from the end or edge of the thick $SiO_2$ film. Detailed explanation of this phenomenon is omitted here since it has been explained by E. Kooi et al in the Journal of Electro-Chemical Society Vol. 123, p 117 (1976). In addition it has also been explained by K. Ohwada et al in the Journal of Japanese Applied Physics Vol. 17, No. 4, P 737 (1978) and that the breakdown voltage of a gate insulating film is not only reduced by the $Si_3N_4$ regions 21 at gate end regions, but that $Si_3N_4$ can also exist in a gate centre region. The reason for this is considered to be as follows; namely, $NH_3$ generated by reaction between $H_2O$ and $Si_3N_4$, because of a crystal defect such as a pin-hole in the $Si_3N_4$ film 3, further reaches the silicon substrate by passing through underlying $SiO_2$ film 2, producing $Si_3N_4$ regions 23.

As indicated in Figure 3, in an ordinary IGFET, $Si_3N_4$ film 3 and $SiO_2$ film 2 are removed after selective oxidation, but the $Si_3N_4$ regions 21 and 23 formed after selective oxidation remain. This is mainly because the $Si_3N_4$ regions 21 and 23 may not exist as pure films but they may be combined in a complicated manner with impurity particles contained in an area near the surface of the single crystal silicon substrate 1 which act as nuclei. Namely, since a gate insulating film is formed with these nitrides remaining in place, a homogeneous film thickness cannot be obtained and as a result the breakdown voltage is reduced. In the case of an ordinary IGFET, the $SiO_2$ film to be provided between a gate electrode and a silicon base plate must be formed as thinly as possible in order to make the electrostatic capacitance at the gate portion large. However, as the $SiO_2$ film becomes thinner, the breakdown voltage is drastically reduced. Reduction of such breakdown voltage poses a large barrier to the improvement of IGFET characteristics.

The reduction of reaction temperature during selective oxidation has been proposed by B. W. Ormont et al in the Electro-Chemical Society Spring Meeting (Boston) Abstract No. 89 P 231 (1979) as a means for solving the problem of reduction of breakdown voltage of gate insulating film because of selective oxidation.

However, a method involving reducing the reaction temperature is inadequate for real use, because whereas an oxidation time of about 5 hours is usually required for obtaining a field oxide film of a thickness of about 800 nm (8000 Å), at a temperature of 1100°C, about 13 to 14 hours are required at a temperature of 950°C.

Moreover, B. W. Ormont et al have also proposed a method of using a thick $Si_3N_4$ film as an oxidation resistant mask. However, it is an undesirable measure to make the $Si_3N_4$ film thick enough to prevent reduction of breakdown voltage because stress applied to the base plate at the time of selective oxidation is increased.

US—A—4 179 311 discloses an IGFET having a silicon substrate, a gate insulating film on a

surface of the substrate, a gate electrode on the insulating film, and a thermally oxidised film formed by selective oxidation on and embedded in the substrate and thicker than the insulating film.

GB—A—2 007 430 discloses an MOS device formed on an epitaxial layer on silicon material with a (100) crystal orientation. A gate insulating film is formed on the epitaxial layer, a gate electrode is formed on the insulating film, and field oxide, thicker than the insulating film, is formed on and embedded in the epitaxial layer.

DE—A—1 817 354 discloses an MOS FET with a single crystal semiconductor substrate with a planar upper surface lying substantially in the (311) crystal plane.

A transistor disclosed in DE—A—1 817 354 is fabricated without the use of a selective oxidation process.

According to the present invention there is provided an insulated gate field effect transistor having a gate insulating film formed on a major plane surface of a single crystal silicon substrate, or on a silcon epitaxial layer formed on a major plane surface of a single crystal silicon base plate, a gate electrode formed on the insulating film, and a thermally oxidised film formed by a selective oxidation process on and embedded in the substrate, or the epitaxial layer, the thermally oxidised film having a greater thickness than the gate insulating film, characterised in that the major plane surface deviates by an angle within the range from substantially 22° to substantially 34° with respect to the {1, 0, 0} crystallographic surface, towards the {1, 1, 1} crystallographic surface.

An embodiment of the present invention can provide an IGFET which allows the use of selective oxidation in its fabrication but does not suffer a reduction of breakdown voltage of the gate insulating film.

An embodiment of the present invention can provide an IGFET with excellent breakdown voltage characteristics even when the gate insulating film is made much thinner and the electrostatic capacitance of the gate portion is made very large.

An embodiment of the present invention can provide an IGFET with excellent breakdown voltage characteristics and function characteristics such as lower threshold voltage and high mutual conductance, for example.

An embodiment of the present invention can provide an IGFET in which the cause of reduced breakdown voltage of the gate insulating film is substantially removed, which does not require increased production steps, or extension of production time.

Preferably, better characteristics, can be obtained for an embodiment of this invention by forming an epitaxial layer on a single crystal base plate as the abovementioned substrate. As the major plane surface of the base plate on which the aforementioned epitaxial layer is grown, the crystallographic surface (3, 1, 1) is particularly recommended, for providing good characteristics, from among the possible major plane surfaces of a single crytal silicon base plate lying within the range of orientations of major plane surface for an embodiment of the present invention. An adequate thickness of the epitaxial layer is 3 µm or more.

Attention will now be given to the surface orientation of a silicon base plate itself on which an IGFET is formed.

A crystallographic surface orientation is determined or described by pairs or groups of three figures which are known as the Miller index of the surface orientation. Detailed explanation of Miller indices is omitted here since they are sufficiently described in other technical references. However, Miller constants or figures within parantheses indicate a certain specific surface, and the brackets or parentheses indicate that a group of surface are intended which are crystallographically equivalent to the specific surface.

Usually, a silicon wafer used for an IGFET has a major plane surface which is the same as the crystallographic surface {1, 0, 0}. This is mainly because this condition has been adopted in the light of considerations concerning the number of charges ($N_{FB}$) induced mainly at the boundary between the single crystal silicon base plate and the gate insulating film, and concerning the mobility (µs) of carriers in regard to the operation of the IGFET at an area near the surface of the base plate. Namely, $N_{FB}$ takes a minimum value for a surface {1, 0, 0}, while µs takes a maximum value. Therefore, an IGFET having a lower threshold voltage and higher mutual conductance can be produced using a base plate with a {1, 0, 0} surface.

However, an IGFET in which the surface (1, 0, 0) is selected as the major plane surface has the lowest breakdown voltage for the gate insulating film as compared with IGFETS where other crystallographic surfaces are selected as the major plane surface, when selective oxidation is executed using an $Si_3N_4$ film as a mask. Moreover, according to experimental results obtained by the inventor of the present invention, when an ordinary selective oxidation process is carried out at a temperature of 1100°C, an IGFET formed on a substrate having a (1, 0, 0) surface as the major plane surface thereof is subject to so-called "short breakdown" in which the gate insulating film breaks down resulting in the establishment of a perfect conductive condition for a lower voltage applied to the gate electrode. On the other hand, an IGFET formed on a (1, 1, 1) surface is subject to so-called "self-heal breakdown" in which the gate insulating film first becomes conductive but is immediately cured even when a voltage higher than that for "short breakdown" by a factor of about 10 is applied.

Explanation of the general mechanism resulting in low breakdown voltage has already been given and therefore is omitted here. Here will be explained the probable reasons why low

breakdown voltage depends on the crystallographic surface selected for use.

Generally, a crystallographic surface is not atomically flat but can be considered as having a kind of step structure. Since the surface {1, 1, 1} of single crystal silicon is considered to coincide (in orientation) with the flat surface of such a step, step density of à surface is considered to increase as the single crystal silicon surface deviates towards a (1, 0, 0) surface away from the (1, 1, 1) surface. Since a thermodynamical kink which exists even in thermally balanced conditions is generated mainly in such a step, kink density increases as does step density when a single crystal silicon surface deviates towards the (1, 0, 0) surface from the (1, 1, 1) surface. More particularly, since a kink location is an area in which particles are absorbed most easily, most impurity particles are estimated to be absorbed at the (1, 0, 0) surface. As explained above, low breakdown voltage after selective oxidation is considered to be caused by nitride generated at the boundary of a silicon base plate as a result of reaction between a selective oxidation mask consisting of $Si_3N_4$ and $H_2O$, and this has been demonstrated in a variety of experimental results. Since the reaction generating such nitride at the boundary of the silicon base plate proceeds on the basis of impurity particles contained in areas near the single crystal silicon base plate surface working as nuclei, the amount of nitride generated at the boundary of the single crystal silicon base plate, which ultimately determines the breakdown voltage, depends on the number of impurity particles absorbed into the single crystal silicon base plate surface. Namely, when the crystallographic surface {1, 1, 1} is used as the main surface of the single crystal silicon base plate, step density at the base plate surface, in the atomic range, is minimized, kink density at the surface is also minimized and the number of impurity particles absorbed into the surface is also minimized; moreover these values are considered to increase as the main surface of the base plate is inclined towards the {1, 0, 0} crystallographic surface. Moreover, since the chemical reaction indicated by the reaction (2) above proceeds in dependence upon the number of impurity particles absorbed into the single crystal silicon base plate surface, the least amount of $Si_3N_4$ is formed at the boundary when the crystallographic surface {1, 1, 1} is used as the single crystal silicon base plate main surface and this amount increases as the base plate main or major surface deviates gradually towards the crystallographic surface {1, 0, 0}.

From the above explanation, it will be understood that when a selective oxidation process is carried out using an $Si_3N_4$ film as a mask, an IGFET has the best breakdown voltage characteristic in a case in which the crystallographic surface {1, 1, 1} is selected as the single crystal silicon base plate major surface, and that such breakdown voltage is reduced as the base plate major surface is deviated towards the surface {1, 0, 0}.

However, an IGFET which is excellent only from the point of view of gate insulating film breakdown voltage cannot be said to be a device offering a sufficiency of good characteristics. If an IGFET cannot satisfy the criteria which define good element characteristics such as a sufficiently small $N_{FB}$ and a sufficiently large $\mu_s$ (the satisfaction of these criteria being the reason why a single crystal silicon base plate in which the crystallographic surface (1, 0, 0) is used as the major plane surface has been mainly used) such an IGFET cannot be said to be a device having excellent characteristics overall.

We have carried out experiments to study how the values of $N_{FB}$, $\mu_s$ and the breakdown voltage of the gate insulating film vary, after a selective oxidation process has been effected using $Si_3N_4$ film as a mask, by forming IGFET's on various silicon substrates having major plane surfaces corresponding to crystallographic surfaces deviating from the (1, 0, 0) surface towards the (1, 1, 1) surface by various amounts. These experiments have proved that the factors mentioned above as defining device characteristics do not increase or decrease linearly in dependence upon the angles of deviation selected for major plane surfaces. Simultaneously, it has been demonstrated that the dependencies on the inclination angle (the deviation) of base plate of $N_{FB}$, $\mu_s$ and breakdown voltage of the gate insulating film, respectively have different forms.

From the explanation above and below it will be understood how an IGFET having excellent overall characteristics, having sufficiently good values of $N_{FB}$, $\mu_s$ and breakdown voltage, can be obtained with a major plane surface of the substrate or base plate of the IGFET lying within a specific range of angles.

First, with regard to the breakdown voltage of the gate insulating film, a sufficiently good value is obtained by providing a substrate or base plate surface corresponding to a crystallographic surface inclined by 22° or more towards the surface (1, 1, 1) away from the surface (1, 0, 0) with reference to an IGFET using a single crystal silicon base plate formed by an ordinary process where the crystallogrpahic surface (1, 0, 0) is used as the major plane surface.

Secondly, sufficiently good functional characteristics are provided for a device when $N_{FB}$ has a value less than the order of $10^{10}/cm^2$, and such a value can be assured when the substrate or base plate surface corresponds to a crystallographic surface deviated by substantially 34° or less away from the surface (1, 0, 0) towards the surface (1, 1, 1).

Thirdly, a suitable range of variation of $\mu_s$ can only be found for substrate or base plate surfaces corresponding to crystallographic surfaces in a range of deviation from 0° to 45° from the (1, 0, 0) surface towards the (1, 1, 1) surface.

As will be understood from the above, an embodiment of the present invention provides an

IGFET using a single crystal silicon substrate or base plate the major plane surface of which is inclined by an angle within a range governed by these factors, namely by an angle from substantially 22° to substantially 34° towards the crystallographic {1, 1, 1} surface from the {1, 0, 0} surface. Consequently, the IGFET has excellent overall characteristics and in particular assures a high breakdown voltage of the gate insulating film even after a selective oxidation using an $Si_3N_4$ film as a mask.

As explained above, in embodiments of the present invention, attention is focused firstly on the crystallographic surface orientation of a single crystal silicon base plate or substrate with a view to improving breakdown voltage of the gate insulating film.

Then, the inventors of the present invention have also given attention to the impurity particles contained in the silicon semiconductor substrate or base plate forming an IGFET, particularly those existing in the area near the substrate or base plate surface. As explained previously, nitride produced during selective oxidation using $Si_3N_4$ film as a mask is a major cause of reduction of breakdown voltage of the gate insulating film, and impurity particles adhering to an area near the surface of a single crystal silicon base plate promote a chemical reaction producing such nitride. The possible crystallographic surface orientations of major plane surfaces of base plates has been considered in the light of the number of impurity particles absorbed into the major plane surfaces when inclined at respective selected angles.

An angle of inclination (a range of angles) is determined for which the number of impurity particles existing at an area near a base plate surface is reduced.

In reality, only a very small number of impurity particles are absorbed into a {1, 1, 1} surface as compared with other surfaces, but this very small number is not zero. Therefore, breakdown voltage of a gate insulating film can be further improved by reducing the number of impurity particles contained in the silicon base plate itself aside from consideration of crystallographic surface orientation.

Currently, an ordinary IGFET is formed on a single crystal silicon base plate in a bulk condition. However, it is generally known that a single crystal silicon layer obtained by epitaxial growth contains a lesser number of impurity particles than the single crystal silicon in the bulk condition. In addition, epitaxial growth occurs in accordance with the same crystal axis as that of a single crystal silicon base plate on which the growth takes place. For example, when an epitaxial layer is grown on a base plate where the crystallographic surface (1, 0, 0) is selected as the major plane surface, the epitaxial layer has the surface (1, 0, 0) as the major plane surface thereof.

Thus, a lesser number of impurity particles are absorbed by a single crystal silicon substrate surface deviating towards the surface (1, 1, 1) by a certain angle (an angle within a certain range) from the surface (1, 0, 0), and the same is also true in regard to an epitaxial layer formed on such a substrate. Moreover, the epitaxial layer contains a lesser number of impurity particles as compared with a substrate in the bulk condition, thereby a single crystal silicon substrate allowing absorption of a still lesser number of impurity particles can be obtained.

In an embodiment of the present invention, as explained previously, the major plane surface of a single crystal silicon substrate is deviated within a range from subtantially 22° to substantially 34° towards the surface (1, 1, 1) from the surface (1, 0, 0), and an epitaxial layer is additionally formed on such a substrate, thereby further improving the breakdown voltage of the gate insulating film.

It is also known that growth of an epitaxial layer of particularly excellent lattice arrangement with crystal axes which match those of a substrate on which the epitaxial layer is formed is provided when the crystallographic surface of the layer or substrate has a surface orientation indicated by a Miller index which is expressed by integers. Within the abovementioned range of angles the crystallographic surface {3, 1, 1}, in correspondence with which a major plane surface is deviated by about 25.2° towards the surface {1, 1, 1} from the surface {1, 0, 0}, is included. Namely, it is desirable to use a substrate having a major plane surface selected to correspond to the crystallographic surface {3, 1, 1} for providing that the crystallographic surface is within the specific range and for realizing epitaxial growth.

When forming an IGFET on or in an epitaxial layer, the thickness of the epitaxial layer must be considered.

In an ordinary IGFET, only an area near the substrate surface is related to the operation of the device. In addition, in an embodiment of the present invention, a particular thickness is not required since the epitaxial layer is formed in order to improve the breakdown voltage of the gate insulating film after selective oxidation, namely to reduce the number of impurity particles adhered to the surface at which the device is formed. However, crystallisation is not so good and is unstable at the boundary between a single crystal substrate and an epitaxial layer. For this reason, it is desirable for formation of an IGFET on a stable epitaxial layer that the epitaxial layer has a thickness of at least 3 µm.

Reference is made, by way of example, to the accompanying drawings, in which:—

Figure 1 is a schematic cross-sectional view of an oxidation resistant mask $Si_3N_4$ film formed on a single crystal silicon substrate over an $SiO_2$ film in an ordinary selective oxidation process;

Figure 2(a) is a schematic cross-sectional view of the substrate after thermal oxidation using the $Si_3N_4$ film as a mask;

Figure 2(b) is a schematic cross-sectional view enlarged as compared with Figure 2(a), illustrating a process where a nitride is formed at the

boundary of the silicon substrate and the $SiO_2$ film at the mask end of the $Si_3N_4$ film of Figure 2(a);

Figure 3 is a schematic cross-sectional view of the substrate when the $Si_3N_4$ film and $SiO_2$ film in a gate region have been removed after an ordinary selective oxidation process;

Figure 4 is a graph illustrating results of various tests relating to IGFETS using single crystal silicon substrates having different crystallographic surface orientations; in the graph, curve A relates to breakdown voltage of gate insulating film, curve B relates to mobility at areas near substrate surfaces, and curve C relates to the number of charges induced at boundaries between substrates and gate insulating films;

Figures 5 to 11 are respective schematic cross-sectional views illustrating the formation of an IGFET using a single crystal silicon substrate in accordance with the present invention; in particular, Figures 5 to 8 show processes for formation of an oxidation resistant $Si_3N_4$ film mask over an $SiO_2$ film, and selective oxidation to form a thick $SiO_2$ film;

Figure 12 is a schematic cross-sectional view of a base plate on which an epitaxial layer is formed on a major plane surface of a single crystal silicon substrate in accordance with the present invention; and

Figure 13 is a schematic cross-sectional view of an IGFET formed using the same processes as described with reference to Figures 5 to 11, but using the base plate indicated in Figure 12.

First, explanation in relation to an embodiment of the present invention will be given with reference to Figure 4.

In Figure 4, curve A indicates results of a breakdown voltage test for gate insulating film. Here single crystal silicon substrates of N or P conductivity types were used and selective oxidation was carried out using an $Si_3N_4$ film as a mask before formation of a gate insulating film. In the selective oxidation, a field oxide film of a thickness of about 780 nm (7800 Å) was formed at a temperature of about 1100°C, as employed for an ordinary oxidation process. Here, the thickness of an $SiO_2$ film formed over the entire major plane surface of the silicon substrate before the selective oxidation process was about 50 nm (500 Å), while the thickness of the $Si_3N_4$ film was about 50 nm (500 Å). After the selective oxidation process, the $Si_3N_4$ film and the $SiO_2$ film formed on the gate portion were removed from the substrate surface, and then an $SiO_2$ film was newly formed to a thickness of about 100 nm (1000 Å) as a gate insulating film.

The vertical axis in Figure 4 indicates a percentage of samples subjected to a test. The horizontal axis indicates the angle of deviation of the crystallogrpahic surface (of the IGFET substrate or base plate) towards the surface (1, 1, 1) from the surface (1, 0, 0) in terms of degrees. IGFET samples with substrates or base plates having major plane surfaces corresponding to crystallographic surfaces deviating by various angles from the surface (1, 1, 1) towards the surface (1, 0, 0) were tested.

For the breakdown voltage test, electrical fields of up to 5 (MV/cm) were applied. This caused perfect breakdown (100% of all IGFET samples broke down and failed the test) and brought about a conductive condition for the gate insulating film for IGFET's whose substrates had the crystallographic surface (1, 0, 0) selected as their major plane surface. The breakdown voltage failure rate for the gate insulating film is maximum and all such samples suffered breakdown.

On the other hand, the failure rate is minimum for IGFET samples with substrate major plane surfaces corresponding to surface (1, 1, 1) inclined by about 54.7° from the surface (1, 0, 0). None of the samples suffered breakdown. Differences in breakdown voltage depending on the conductivity type of the substrate could not be found. Dependence on inclination angle of the crystallographic surface corresponding to IGFET substrate major plane surface of the breakdown voltage failure rate indicates gradual improvement over the range of inclination angles from 10° to 40°.

It can generally be said that a reduction of breakdown voltage of gate insulating film has obviously been prevented when a breakdown voltage failure rate of 50% or less with an electrical field as high as (5 MV/cm) (which causes a breakdown failure rate of 100% when the crystallographic surface (1, 0, 0) is selected in an ordinary IGFET) is obtained. From Figure 4, the breakdown voltage failure rate of 50% is obtained at the point where the crystallographic surface corresponding to the IGFET substrate major plane surface is deviated by substantially 22° towards the surface (1, 1, 1) from the surface (1, 0, 0). Thus, a gate insulating film consisting of $SiO_2$ of a thickness of about 100 nm (1000 Å) suffers a low incidence of breakdown for application of a gate voltage of about 30V or less, and as a result of IGFET having an excellent breakdown voltage characteristic can be obtained.

Curve C in Figure 4 indicates the form of dependence on the crystallographic surface orientation (of IGFET substrate major plane surface) of the number of charges $N_{FB}$ induced at the boundary of a single crystal silicon substrate and an $SiO_2$ film used as a gate insulating film. The results of tests given by curve C were obtained using $SiO_2$ film as gate insulating film formed by the same process as for the breakdown voltage test. Here, the vertical axis indicates the value of $N_{FB}$ in terms of percentage of the value of $N_{FB}$ when IGFET substrate main plane surface correspond to surface (1, 1, 1). The values of $N_{FB}$ increase when the crystallographic surface orientation (corresponding to IGFET substrate main plane surface) deviates by 20° or more from the surface (1, 0, 0). The $N_{FB}$ value determines a boundary level and is a factor in determining many functional characteristics such as threshold voltage and mutual conductance. $N_{FB}$ becomes $10^{11}/cm^2$ or more when the IGFET substrate main

plane surface is deviated by 34° or more towards the surface (1, 1, 1) from the surface (1, 0, 0) and an element superior in functional characteristics cannot be obtained.

Curve B in Figure 4 indicates the form of dependence on the crystallographic surface orientation (of IGFET substrate main or major plane surface) of the mobility $\mu_s$ of carriers in an area related to the operation of the IGFET near the silicon substrate surface. The vertical axis indicates the values of $\mu_s$ in terms of percentages of $\mu_s$ when the crystallographic surface (1, 0, 0) corresponds to IGFET substrate main or major plane surface. The mobility $\mu_s$ changes little until the inclination angle of the crystallographic surface corresponding to IGFET substrate major plane surface reaches about 45°.

From the results A to C in Figure 4, namely from respective requirements concerning breakdown voltage of gate insulating film, mobility $\mu_s$ and number of charges $N_{FB}$ at the boundary, the embodiments of the present invention provide that the major plane surface of the single crystal silicon substrate used for an IGFET is deviated within the range from substantially 22° to substantially 34° towards the crystallographic surface {1, 1, 1} from {1, 0, 0}.

Moreover, it is desirable in an embodiment of the present invention to provide for epitaxial growth on a single crystal silicon substrate or base plate. In regard to the factors such as $N_{FB}$, $\mu_s$ which determine the functional characteristics of an IGFET as indicated in Figure 4, distinctive changes cannot be found when epitaxial growth is performed (as compared with a case where no epitaxial growth is effected).

However, the breakdown voltage failure rate of gate insulating film is very much improved as a whole by providing an epitaxial layer. Therefore, in order to further improve the breakdown voltage characteristic of an IGFET, an epitaxial layer is grown on a single crystal silicon substrate or base plate of which the major plane surface is deviated by substantially 22° to substantially 34° towards the crystallographic surface {1, 1, 1} from the surface {1, 0, 0}. Moreover, an epitaxial layer having a good crystallisation can be obtained by using such a substrate with a major plane surface corresponding to a crystallographic surface within the range indicated above, particularly with a major plane surface corresponding to the surface {3, 1, 1}, as the major plane surface of the substrate for the epitaxial layer. In addition, an adequate thickness of epitaxial layer is 3 μm or more for the abovementioned reasons, and a thicker epitaxial layer obtained by epitaxial growth will not provide any particular improvement in element characteristics and will only increase the time required for forming the epitaxial layer. Thus, in reality, an epitaxial layer of a thickness of about 3 μm is obtained by epitaxial growth.

A preferred process for forming an IGFET embodying the present invention will be explained below.

Figures 5 to 11 illustrate the formation of an IGFET using a substrate of which the major plane surface is deviated as described above.

In Figure 5 an $SiO_2$ film 32 and an $Si_3N_4$ film 33 are respectively formed on a single crystal silicon substrate. First of all, a single crystal silicon substrate 31 of P type conductivity, a specific resistance of about 10 ohms, and a thickness of about 600 μm is prepared with its major plane surface selected to correspond to a crystallographic surface which deviates by 25° towards the surface {1, 1, 1} from the surface {1, 0, 0}. Thereafter, the entire surface of the single crystal silicon substrate 31 is oxidised under an oxygen ambient including about 5% HCl. After an oxidation process lasting about 30 minutes, an $SiO_2$ film 32 of about 50 nm (500 Å) thickness is obtained. Then, an $Si_3N_4$ film 33 is formed on the $SiO_2$ film by an ordinary CVD (chemical vapour deposition) method. The growth of $Si_3N_4$ is effected at a temperature of about 800°C under an ambient of $SiH_4$:$NH_3$=1:50, being typical epitaxial growth conditions, and thereby a thickness of about 50 nm (500 Å) can be obtained for the film 33.

Figure 6 shows the $Si_3N_4$ film 33 remaining only on an IGFET forming area.

To provide this, resist is coated over the whole of the major plane surface of the single crystal silicon substrate 31 and that part of the resist corresponding to the IGFET forming region is developed by patterning. Thereafter, the $Si_3N_4$ film 33 is retained only on the IGFET forming area; other areas of film 33 being removed by means of a conventional plasma etching method. Moreover, as in the case of an ordinary IGFET, boron ions in an amount or dosage of about $3.5\times10^{13}/cm^2$ are injected with an energy of about 40 KeV into the major plane surface of the substrate using the retained $Si_3N_4$ film 33 as a mask, in order to form a channel cut region.

Figure 7 shows a thick $SiO_2$ film 35 formed using the retained $Si_3N_4$ film 33 as a mask by a thermal oxidation process. Since the $Si_3N_4$ film has excellent oxidation resistance characteristic, it is used as an oxidation mask in an ordinary selective oxidation process. This $Si_3N_4$ film has the problem mentioned previously, but is used here as oxidation mask since an alternative is not available.

Typically, on the region from which the $Si_3N_4$ film has been removed, an $SiO_2$ film 35 of a thickness of about 780 nm (7800 Å is formed by a thermal oxidation process, lasting for about 4 hours at a temperature of about 1100°C under a wet oxygen ($O_2$) ambient (containing water vapour). Simultaneously, boron ions injected previously are activated as a result of the annealing process (heating), thus forming $p^+$ region 34 which will become a channel cut region.

Figure 8 shows the thin $SiO_2$ film 32 to be removed from the $Si_3N_4$ film 33 and the IGFET forming region.

$SiO_2$ formed in an area near the surface of the $Si_3N_4$ film 33 (the top of film 35) is removed using

buffer-HF as etching solution. Next, the $Si_3N_4$ film 33 is removed from the surface of the substrate using hot $H_3PO_4$ as etching solution. Moreover, the comparatively thin $SiO_2$ film 32 on the IGFET forming region is removed using buffer-HF as etching solution. Here, in an ordinary single crystal silicon substrate where the crystallographic surface (1, 0, 0) is selected to correspond to the major plane surface nitride newly produced by the selective oxidation process still remains, even after etching, in the IGFET forming region, but when using a substrate in accordance with the present invention where the major plane surface is selected to correspond to a crystallographic surface deviated by 25° towards the surface {1, 1, 1} from the surface {1, 0, 0}, the nitride compound is not formed to any substantial extent at the boundary of the single crystal silicon substrate, and is left in place, as indicated in Figure 8, even after removal of $SiO_2$ film 32 (compare Figure 3).

Figure 9 shows a gate insulating film 36 formed on the single crystal silicon substrate 31.

The gate $SiO_2$ film 36 is formed to a thickness of about 50 nm (500 Å) on the IGFET forming region under an oxygen ambient containing about 5% HCl at about 1100°C. Here, since the boundary of the single crystal silicon substrate 31 and the $SiO_2$ film 36 is very stable as indicated in Figure 8, a good $SiO_2$ film 36 having a homogeneous thickness can be formed.

Figure 10 shows $n^+$ source and drain regions 37 provided separately within the single crystal silicon substrate 31 and a gate electrode 38 of polysilicon formed on the gate $SiO_2$ film 36.

The poly-silicon is formed by a CVD method on the exposed upper surface, then a resist film is coated on the surface of the poly-silicon film, patterning is effected only in the gate electrode forming region, and gate electrode 38 is formed by etching the poly-silicon film with nitric or fluoric acid. On the other hand, ion implantation is carried out only in respect of the area where thin $SiO_2$ film 36 is formed on the single crystal silicon substrate, using the gate electrode 38 as a mask. Here, as ions for implantation, As ions in an amount or dosage of $4\times10^{15}/cm^2$ are implanted with an energy of about 120 KeV. Thereafter, the As ions implanted previously are activated, thereby forming source/drain regions 37 having $n^+$ type conductivity.

Figure 11 show a completed IGFET with electrodes extending from the source/drain regions 37.

First, a PSG film 39 is formed over all upper surfaces by a CVD method using $SiH_4$, $PH_4$ and $O_2$ gases. Thereafter, boring or perforation is effected by an etching method in respect of the PSG film 39 and the thin $SiO_2$ film 36 for providing windows for contact with the source/drain regions 37. Aluminium is evaporated on, and patterned, to provide electrodes 40, thus completing the IGFET.

In Figures 5 to 11, a process for forming an IGFET using a single crystal silicon substrate in accordance with an embodiment of the present invention has been indicated. Figures 12 and 13 illustrate processes for forming an IGFET using an epitaxial layer in accordance with an embodiment of the present invention.

Figure 12 shows a silicon substrate in an embodiment of the present invention in which an epitaxial layer is formed. A p type epitaxial layer 41, of the same conductivity type as substrate 41, and having a specific resistance of 10 ohms, is formed to a thickness of about 3 µm on a single crystal silicon substrate which has a major plane surface selected to correspond to the crystallographic surface (3, 1, 1). Here, the crystallographic surface orientation of the major plane surface of the epitaxial layer is also (3, 1, 1).

Figure 13 shows an IGFET completed in the epitaxial layer 42.

Substantially the same processes as explained with reference to Figures 5 to 11 are used for forming an IGFET in the epitaxial layer 42. In Figure 13, 44 is a $P^+$ type channel cut region; 45 is a thick $SiO_2$ film; 46 is a thin $SiO_2$ film of the gate portion; 47 is an $n^+$ type source/drain region; 48 is a gate electrode of poly-silicon; 49 is a PSG film; and 50 is an aluminium electrode.

An embodiment of the present invention provides an IGFET formed on a single crystal silicon substrate the major plane surface of which is deviated within the range from substantially 22° to substantially 34° towards the crystallographic surface {1, 1, 1} from the surface {1, 0, 0}, or on a silicon epitaxial layer formed on the substrate. This suppresses generation of silicon nitride under a mask in a selective oxidation process using silicon nitride as a mask, which silicon nitride is the main cause of reduction of breakdown voltage of the gate insulating film of an IGFET. In addition, various functional characteristics of the IGFET which depend on the crystallographic surface orientation are not subject to deterioration. Thereby, an embodiment of the present invention can provide an IGFET with drastically improved gate insulating film breakdown voltage failure rate whilst maintaining other characteristics in good condition.

**Claims**

1. An insulated gate field effect transistor, having a gate insulating film (36, 46) formed on a major plane surface of a single crystal silicon substrate (31), or on a silicon epitaxial layer (42) formed on a major plane surface of a single crystal silicon base plate (41), a gate electrode (38, 48) formed on the insulating film (36, 46), and a thermally oxidised film (35, 45) formed by a selective oxidisation process on and embedded in the substrate (31), or the epitaxial layer (42), the thermally oxidised film (35, 45) having a greater thickness than the gate insulating film (36, 46), characterised in that the major plane surface deviates by an angle within the range from substantially 22° to substantially 34° with respect

to the {1, 0, 0} crystallographic surface, towards the {1, 1, 1} crystallographic surface.

2. A transistor as claimed in claim 1, wherein the major plane surface of the substrate (31), or the base plate (1), corresponds to the {3, 1, 1} crystallographic surface.

3. A transistor as claimed in claim 1 or 2, wherein the gate insulating film (43) is formed on a silicon layer (42) formed on the major plane surface of a single crystal silicon base plate (41), and wherein the silicon epitaxial layer (42) has a thickness of not less than 3 µm.

**Patentansprüche**

1. Feldeffekttransistor mit isoliertem Gate, mit einem Gateisolierfilm (36, 46), welcher auf einer Hauptebenenoberfläche eines einkristallinen Siliziumsubstrats (31) gebildet ist, oder auf einer epitaktischen Siliziumschicht (42), welche auf einer Hauptebenenoberfläche einer einkristallinen Siliziumbasisplatte (41) gebildet ist, einer Gateelektrode (38, 48), die auf dem Isolierfilm (36, 46) gebildet ist, und einem thermisch oxidierten Film (35, 45), der durch selektiven Oxidationsprozeß auf dem Substrat (31) gebildet und in diesem eingebettet ist, oder der epitaktischen Schicht (42), wobei der thermisch oxidierte Film (35, 45) eine größere Dicke als der Gateisolierfilm (36, 46) hat, dadurch gekennzeichnet, daß die Hauptebenenoberfläche bezüglich der {1, 0, 0} kristallographischen Oberfläche um einen Winkel innerhalb des Bereiches von im wesentlichen 22° bis im wesentlichen 34° zu der {1, 1, 1} kristallographischen Oberfläche hin abweicht.

2. Transistor nach Anspruch 1, bei welchem die Hauptebenenoberfläche des Substrats (31) oder der Basisplatte (1) der {3, 1, 1} kristallographischen Oberfläche entspricht.

3. Transistor nach Anspruch 1 oder 2, bei welchem der Gateisolierfilm (43) auf eine Siliziumschicht (42) gebildet ist, die auf der Hauptebenenoberfläche einer einkristallinen Siliziumbasisplatte (41) gebildet ist, und bei welchem die epitaktische Siliziumschicht (42) eine Dicke von nicht weniger als 3 µm hat.

**Revendications**

1. Transistor à effet de champ à porte isolée, comportant une couche isolante de porte ou grille (36, 46) formée sur une surface plane principale d'un substrat en silicium monocristallin (31), ou sur une couche épitaxiale de silicium (42) formée sur une surface plane principle d'une plaque de base en silicium monocristallin (41), une électrode de grille (38, 48) formée sur la couche isolante (36, 46), et une couche oxydée thermiquement (35, 45) formée par un procédé d'oxydation sélective sur et enfouie dans le substrat (31), ou dans la couche épitaxiale (42), la couche oxydée thermiquement (35, 45) ayant une épaisseur supérieure à celle de la couche isolante de grille (36, 46), caractérisé en ce que la surface plane principale dévie d'un angle compris entre essentiellement 22° et essentiellement 34° par rapport à la surface cristallographique {1, 0, 0}, vers la surface cristallographique {1, 1, 1}.

2. Transistor selon la revendication 1, caractérisé en ce que la surface plane principale du substrat (31), ou de la plaque de base (1), correspond à la surface cristallographique { 3, 1, 1}.

3. Transistor selon l'une quelconque des revendications 1 et 2, caractérisé en ce que la couche isolante de grille (43) est formée sur une couche de silicium (42) qui est formée sur la surface plane principale d'une plaque de base en silicium monocristallin (41), et en ce que le couche épitaxiale de silicium (42) a une épaisseur au moins égale à 3 µm.

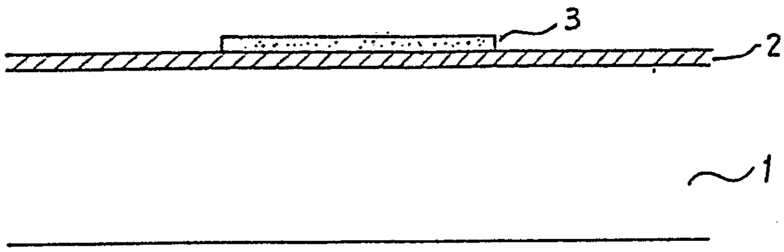


Fig 1

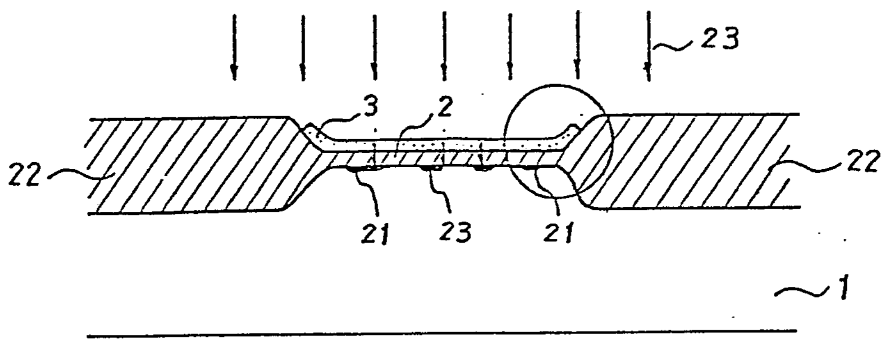


Fig 2a

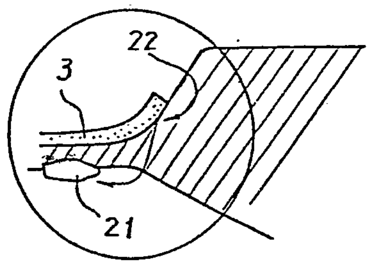


Fig. 2b

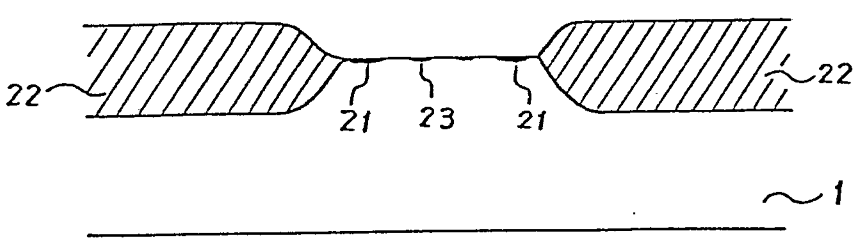


Fig. 3

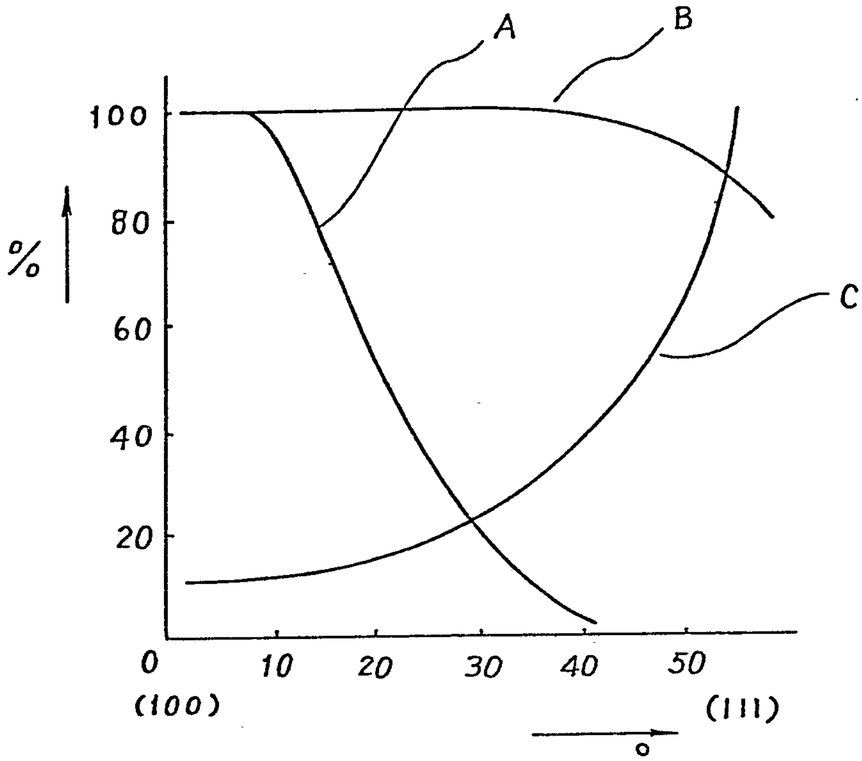


Fig. 4

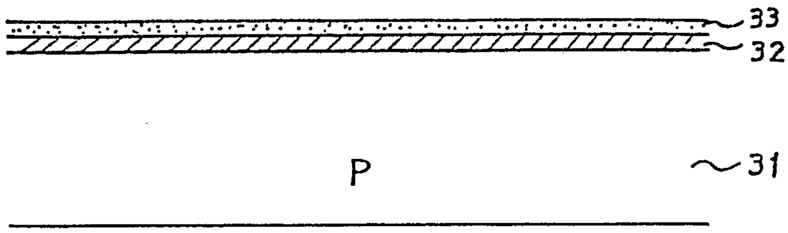


Fig. 5

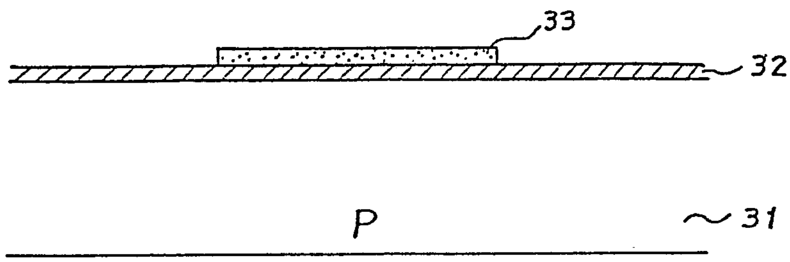


Fig. 6

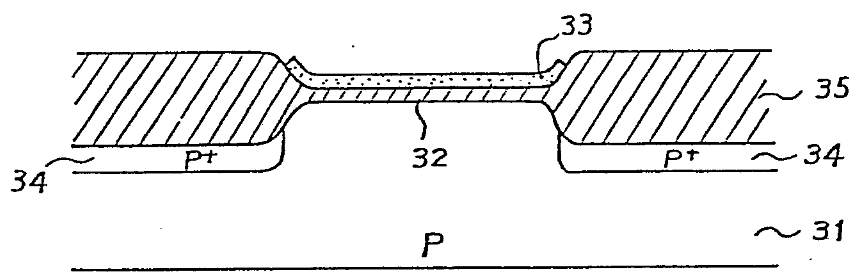


Fig. 7

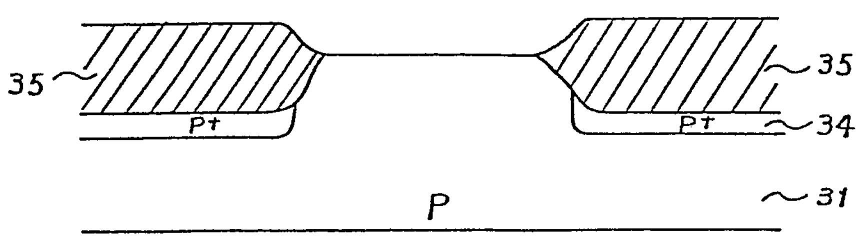


Fig. 8

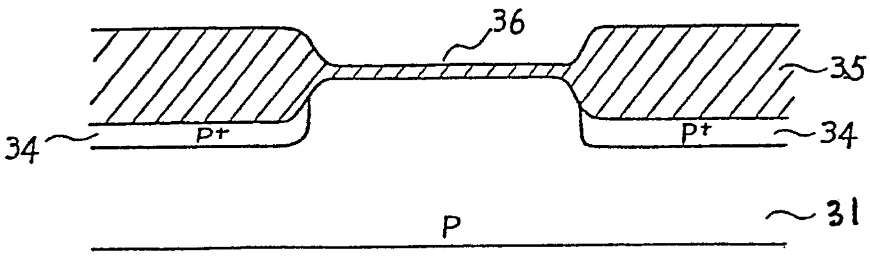


Fig. 9

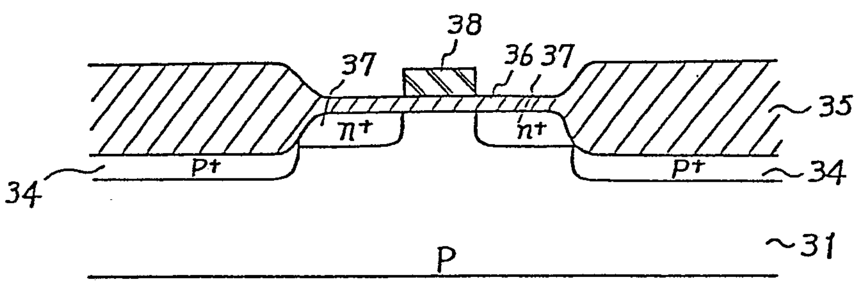


Fig 10

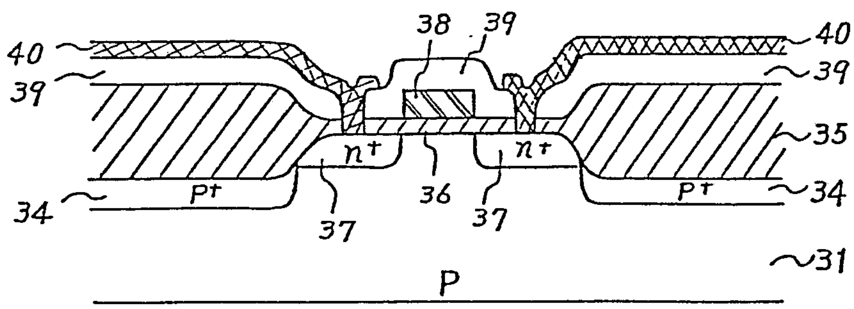


Fig 11

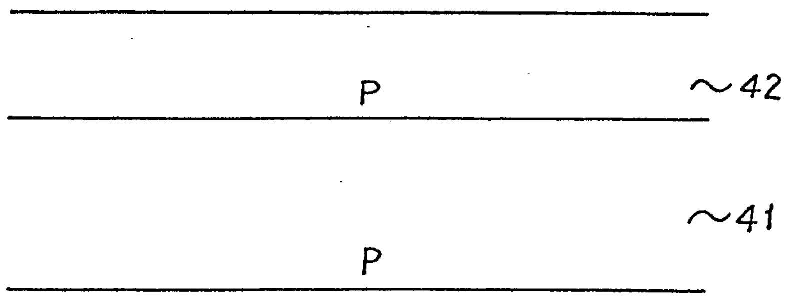


Fig 12

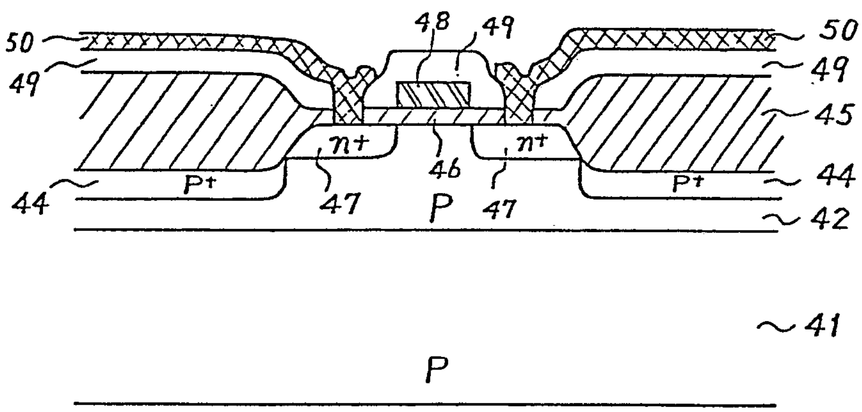


Fig 13